# EUROPEAN PATENT APPLICATION

(11) **EP 4 737 735 A1**
(43) Date of publication of application: **06.05.2026**
(21) Application number: 24899369.3
(22) Date of filing: 30.08.2024
(51) Int. Cl.: F04D 25/08, G06F 1/20, H05K 7/20

(54) **FAN MODULE AND ELECTRONIC DEVICE**

(30) Priority: 08.12.2023 CN 202311692885
(71) Applicant: Huawei Technologies Co., Ltd., Shenzhen, Guangdong 518129 (CN)
(72) Inventor: GUO, Zhi, Shenzhen, Guangdong 518129 (CN); CHEN, Yuanyuan, Shenzhen, Guangdong 518129 (CN); ZHU, Mingchao, Shenzhen, Guangdong 518129 (CN); WU, Ruikang, Shenzhen, Guangdong 518129 (CN)
(74) Representative: Maiwald GmbH
(86) International application number: PCT/CN2024/116119
(87) International publication number: WO 2025/118723

(57) **Abstract**

Embodiments of this application provide a fan module and an electronic device, to resolve a problem of an excessive thickness of an electronic device in a related technology. The electronic device includes a housing, a fan casing, and a fan body. The housing includes a first structural member and a second structural member. The second structural member is disposed around an edge of the first structural member. The fan casing encloses the exterior of the fan body. A first portion of the fan casing and the first structural member jointly form a flat plate structure. The flat plate structure and the second structural member jointly enclose mounting space. The fan body is located in the mounting space. The first portion of the fan casing includes a first surface. The first structural member includes a second surface. Both the first surface and the second surface are located on a side that is of an appearance plate and that is away from the mounting space. The second surface and the first surface are located on a same plane. This helps reduce an assembly spacing between the fan casing and the first structural member, thereby reducing a thickness of the electronic device.

## Description

This application claims priority to Chinese Patent Application No. 202311692885.1, filed with China National Intellectual Property Administration on December 8, 2023 and entitled "FAN MODULE AND ELECTRONIC DEVICE", which is incorporated herein by reference in its entirety.

### TECHNICAL FIELD

Embodiments of this application relate to the field of electronic product technologies, and in particular, to a fan module and an electronic device.

### BACKGROUND

With advancement of science and technology, current electronic devices develop toward multi-functionality, high speeds, and small sizes. Some chips in an electronic device, for example, a system on chip (system on chip, SoC), are increasingly integrated, and an amount of computation in a data processing process is also increasing. This results in a great increase in operating heat generated by a processor in a unit area, and the processor becomes a high-heat-generating element. The operating heat generated by the high-heat-generating element affects performance and service lives of the processor and another component in the electronic device.

Currently, a heat dissipation technology employed by the electronic device is mainly an air-cooling apparatus combining a heat dissipation assembly and a fan, to improve a heat dissipation capability of the entire electronic device. However, the electronic device using the air-cooling apparatus is thick. This is not conducive to achieving a light weight and thinning of the electronic device.

### SUMMARY

Embodiments of this application provide a fan module and an electronic device, to resolve a problem in a related technology that an electronic device is thick, which is not conducive to achieving a light weight and thinning of the electronic device.

To achieve the foregoing objective, embodiments of this application provide the following solutions.

According to one aspect, a fan module is provided, including a housing, a fan casing, and a fan body. The housing includes a first structural member and a second structural member. The second structural member is disposed around an edge of the first structural member. The fan casing encloses the exterior of the fan body. The fan casing includes a first portion and a second portion. The first portion and the first structural member jointly form a flat plate structure. The flat plate structure and the second structural member jointly enclose mounting space. The fan body and the second portion are located in the mounting space. Herein, the "flat plate structure" may be used as a main unit appearance board of an electronic device, or may be used as a part of a middle frame of a main unit. Herein, "the first portion and the first structural member jointly form the flat plate structure" may be understood as follows: The first portion and the first structural member are integrally formed, and an integrally formed structure is the flat plate structure; or the first portion is connected to the first structural member, so that the first portion and the first structural member that are connected together jointly form the flat plate structure, and there may be a specific assembly gap or an assembly step difference between the first portion and the first structural member.

The first portion includes a first surface. The first structural member includes a second surface. Both the first surface and the second surface are located on a side that is of an appearance plate and that is away from the mounting space. The second surface and the first surface are located on a same plane. Herein, the "plane" may be understood as an absolutely flat surface or an approximately flat surface, the approximately flat surface may slightly fluctuate, and an acceptable deviation range of the approximately flat surface may be, for example, a deviation within 5%. Through the foregoing arrangement, the first portion and the first structural member form the flat plate structure. This helps reduce an assembly spacing between the fan casing and the first structural member, and reduce space occupied by the fan casing in mounting space, thereby helping reduce a thickness of the electronic device and achieving a light weight and thinning of the electronic device.

In some implementations, the fan body includes a shaft base, fan blades, and a stator assembly. The shaft base is connected to the first portion. The stator assembly is connected to the shaft base. The fan blade is rotatably connected to the shaft base. The fan blade includes a magnetic element. The fan casing further includes a communication hole. The electronic device further includes a circuit board. The circuit board is located in the mounting space. The circuit board extends into the fan casing through the communication hole and is electrically connected to the stator assembly. Through the foregoing arrangement, a mainboard may control the circuit board to supply power to a stator coil, and after the stator coil is energized, a rotating electromagnetic field is generated.

In some implementations, a protrusion structure is provided on a side that is of the first portion and that is close to the mounting space. A first sub-surface is provided on a side that is of the protrusion structure and that is close to the mounting space. The first sub-surface is provided opposite to the first surface. The first sub-surface is recessed toward a side close to the first surface to form a mounting groove. The shaft base is mounted in the mounting groove. Through the foregoing arrangement, the fan body may be mounted on the first portion through the protrusion structure, and connection strength of the fan body is improved by partially increasing a thickness of the first portion.

In some implementations, the first sub-surface is parallel to the first surface and is perpendicular to a rotation axis of the fan blade. Through the foregoing arrangement, interference between the fan blade in a rotation process and the first sub-surface is avoided. This helps reduce scratches of the fan blade.

In some implementations, the first portion further includes a second sub-surface adjacent to the protrusion structure. The second sub-surface is provided opposite to the first surface. The second sub-surface is parallel to the first surface and is perpendicular to the rotation axis of the fan blade. Through the foregoing arrangement, the interference between the fan blade in the rotation process and the first sub-surface is avoided. This helps reduce scratches of the fan blade. In addition, the foregoing arrangement further helps ensure a size of the mounting space enclosed by the first portion, the first structural member, and the second structural member, and increase the mounting space.

In some implementations, a third sub-surface is provided on a side that is of the first structural member and that is close to the mounting space. The third sub-surface is provided opposite to the second surface. At least a part of the third sub-surface and at least a part of the second sub-surface are located on a same plane. The foregoing arrangement helps improve regularity of the first structural member, further ensure the size of the mounting space enclosed by the first portion, the first structural member, and the second structural member, and increase the mounting space.

In some implementations, the circuit board includes a first plate portion, a second plate portion, and a bent portion. The first plate portion is connected to the first sub-surface. The second plate portion is connected to the second sub-surface and passes through the communication hole. The bent portion is connected between the first plate portion and the second plate portion. Through the foregoing arrangement, the circuit board can be mounted on the first portion, and further, space occupied by the circuit board in the mounting space can be reduced. In addition, the second plate portion may further pass through the communication hole, so that the second plate portion can extend out of the fan casing through the communication hole and is electrically connected to the mainboard of the electronic device.

In some implementations, the first portion and the first structural member are of an integrated structure. The first portion and the first structural member are disposed as the integrated structure, to help improve connection strength between the first portion and the first structural member.

In some implementations, the second portion includes a frame and a cover plate. The frame is located between the first portion and the cover plate. The frame is disposed around edges of the first portion and the cover plate. The frame and the cover plate are of an integrated structure. The frame and the cover plate are disposed as the integrated structure, to help improve connection strength between the frame and the cover plate, and further improve overall structural strength of the second portion. In addition, the frame and the cover plate are of an integrated structure. This helps further improve sealing performance between the frame and the cover plate, and the second portion and a part of the first portion form a sealed air outlet channel, thereby preventing air backflow and improving a heat dissipation capability of a fan assembly.

In some implementations, the frame is detachably connected to the side that is of the first structural member and that is close to the mounting space. The fan module further includes a sealing structure. The sealing structure is located between the first portion and the frame. The foregoing arrangement helps the second portion and the part of the first portion form the sealed air outlet channel, thereby preventing air backflow and improving the heat dissipation capability of the fan assembly.

In some implementations, a recessed structure is further provided on the side that is of the first portion and that is close to the mounting space. The recessed structure and the frame jointly enclose the communication hole. A part of the sealing structure is located in the communication hole. The circuit board is located between the sealing structure and the recessed structure. Through the foregoing arrangement, sealing effect between the circuit board and the frame is improved. In addition, in comparison with arrangement of the circuit board between the sealing structure and the frame, arrangement of the circuit board between the sealing structure and the recessed structure helps prevent the frame from crushing the circuit board.

In some implementations, the first structural member is provided with a mounting opening that runs through the first structural member, and at least a part of the first portion is located in the mounting opening. Through the foregoing arrangement, the first structural member and the first portion jointly form the flat plate structure. This helps reduce the assembly spacing between the fan casing and the first structural member, and reduce a thickness of a part of the first structural member, thereby helping reduce the thickness of the electronic device and achieving a light weight and thinning of the electronic device.

In some implementations, the first structural member includes a bottom plate and a lapping block. The bottom plate is provided with the mounting opening that runs through the bottom plate. The second surface is provided on a side that is of the bottom plate and that is away from the mounting space. A side surface adjacent to the second surface is further provided on the bottom plate. The side surface encloses the mounting opening. The lapping block is connected to a side that is of the bottom plate and that is close to the mounting space. In a direction that is parallel to the second surface and that points from the side surface to the rotation axis of the fan blade, the lapping block extends beyond the side surface. A surface that is of the lapping block and that is adjacent to the side surface is a lapping surface. The lapping surface is in contact with the side that is of the first portion and that is close to the mounting space.

In some implementations, a part of the bottom plate and a part of the first portion jointly form a welding block. A third surface is provided on a side that is of the welding block and that is away from the mounting space. At least a part of the third surface, at least a part of the first surface, and at least a part of the second surface are located on a same plane. Through the foregoing arrangement, the lapping block can limit the first portion, and the first portion does not move in a direction close to the mounting space. In addition, because the lapping block is connected to the side that is of the bottom plate and that is close to the mounting space, during mounting of the fan casing, the fan casing may be extended into the mounting space from the outside of a housing, and the first portion made in contact with the lapping surface, to facilitate mounting and fastening of the fan casing.

In some implementations, the second portion includes the frame and the cover plate. The frame is located between the first portion and the cover plate. The frame is disposed around the edge of the cover plate. There is a preset distance between the frame and the side surface in the direction that is parallel to the second surface and that points from the side surface to the rotation axis of the fan blade. The foregoing arrangement helps ensure a distance between a welding position and the frame, avoid impact of a high temperature on the frame in a welding process, and improve structural reliability of the frame.

In some implementations, the fan module may further include a decoration layer. The decoration layer is located on a side that is of the bottom plate and the first portion and that is away from the mounting space. The decoration layer is disposed, to help improve appearance aesthetics of the electronic device. In an embodiment in which the part of the bottom plate and the part of the first portion jointly form the welding block, the decoration layer further covers the welding block, to prevent the welding block from being exposed. This helps further improve aesthetics of the electronic device.

According to another aspect, an electronic device is provided, including a mainboard and the fan module according to any one of the foregoing embodiments. The mainboard is connected to a fan body of the fan module. The electronic device provided in this embodiment of this application includes the foregoing fan module, and therefore has all the foregoing beneficial effect. Details are not described herein again.

### BRIEF DESCRIPTION OF DRAWINGS

FIG. 1 is a cross-sectional view of an electronic device according to some embodiments;
FIG. 2 is a diagram of a structure of a fan module according to some embodiments;
FIG. 3 is a cross-sectional view of an electronic device according to an embodiment of this application;
FIG. 4 is a cross-sectional view of a fan module according to an embodiment of this application;
FIG. 5 is a cross-sectional view of a flat plate structure in an electronic device in FIG. 4;
FIG. 6 is a partial enlarged view at a position A in an electronic device in FIG. 4;
FIG. 7 is a cross-sectional view of another electronic device according to an embodiment of this application;
FIG. 8 is a cross-sectional view of another fan module according to an embodiment of this application;
FIG. 9 is a cross-sectional view of a first structural member of an electronic device in FIG. 8;
FIG. 10 is a cross-sectional view of a first portion of an electronic device in FIG. 8;
FIG. 11 is a cross-sectional view of a first structural member present before welding according to an embodiment of this application;
FIG. 12 is a cross-sectional view of a structure obtained by lapping a first portion over a first structural member according to an embodiment of this application;
FIG. 13 is a cross-sectional view of a structure obtained by welding a first portion to a first structural member according to an embodiment of this application;
FIG. 14 is a cross-sectional view of a structure obtained by grinding a first portion and a first structural member according to an embodiment of this application; and
FIG. 15 is a cross-sectional view of a structure obtained by spraying a decoration layer on surfaces of a first portion and a first structural member according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms such as "first" and "second" mentioned below are merely intended for ease of description, and shall not be understood as an indication or implication of relative importance or implicit indication of a quantity of indicated technical features. Therefore, a feature limited by "first" or "second" may explicitly or implicitly include one or more features. In descriptions of this application, unless otherwise stated, "a plurality of" means two or more.

In embodiments of this application, terms such as "example" or "for example" indicate giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner.

In embodiments of this application, for example, on, under, left, right, front, and rear are relative direction indications used to explain structures and movement of different parts in this application. These indications are appropriate when the parts are in positions shown in the figure. However, if descriptions of the positions of the parts change, these direction indications correspondingly change.

Here, "parallel" and "perpendicular" include the described cases and cases similar thereto. A range of the similar case is within an acceptable deviation range. The acceptable deviation range is determined by a person of ordinary skill in the art by considering an error (that is, a limitation of a measurement system) related to measurement being discussed and measurement of a specific quantity. For example, "parallel" includes absolutely parallel and approximately parallel, and an acceptable deviation range of approximately parallel may be, for example, a deviation within 5%. Similarly, "perpendicular" includes absolutely perpendicular and approximately perpendicular, and an acceptable deviation range of "approximately perpendicular" may also be, for example, a deviation within 5%.

An embodiment of this application provides an electronic device. The electronic device may be a terminal product such as a mobile phone (mobile phone), a tablet computer (pad), a television, an intelligent wearable product (for example, a smart watch or a smart band), or an in-vehicle computer. A specific form of the electronic device is not particularly limited in embodiments of this application.

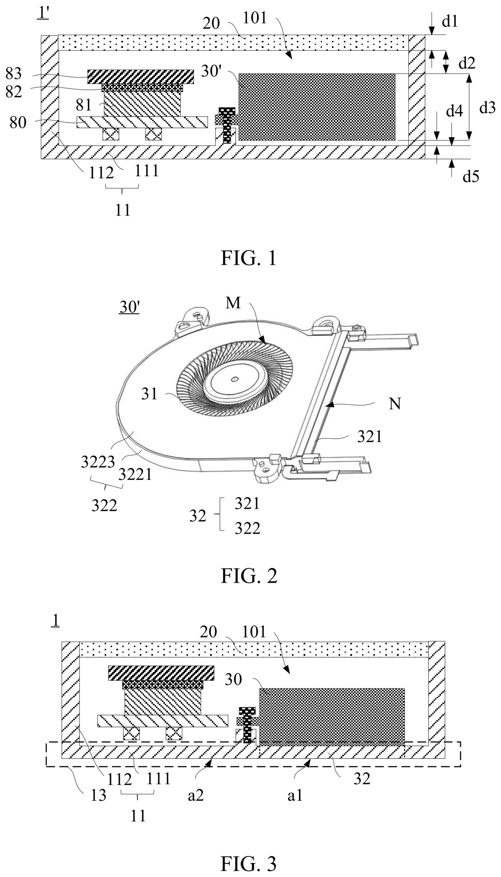

In some embodiments, the electronic device may be a 2-in-1 computer. In other words, the electronic device may be used as a common tablet computer, or may be used as a notebook computer, to meet different use requirements. FIG. 1 is a cross-sectional view of an electronic device 1' according to some embodiments. As shown in FIG. 1, the electronic device 1' may include a housing 11. The housing 11 may include, for example, a first structural member 111 and a second structural member 112, and the second structural member 112 may be disposed around an edge of the first structural member 111. For example, the first structural member 111 may be approximately a rectangular plate, the second structural member 112 may be a flat plate structure disposed around an edge of the rectangular plate, and the first structural member 111 and the second structural member 112 may enclose a box structure.

In some embodiments of this application, the first structural member 111 and the second structural member 112 may be of an integrated structure, and jointly form the housing of the electronic device 1'. For example, materials of the first structural member 111 and the second structural member 112 may include metals such as magnesium alloy and stainless steel. The first structural member 111 and the second structural member 112 may be integrally formed by using a stamping process. In addition, the materials of the first structural member 111 and the second structural member 112 may further include plastic, glass, ceramic, and the like. The materials of the first structural member 111 and the second structural member 112 are not specifically limited in this embodiment of this application.

In some embodiments, the electronic device 1' may further include a display module 20 mounted on the second structural member 112. The display module 20 is configured to display an image. The display module 20 is provided with a display surface configured to display an image, and a back surface away from the display panel. The back surface of the display module 20 may face the first structural member 111.

In some embodiments of this application, the display module 20 may be a liquid crystal display module. In this case, the display module 20 includes a liquid crystal display (liquid crystal display, LCD) and a backlight module (backlight unit, BLU) located on a back surface of the liquid crystal display (a side surface b1 that is away from the LCD and that is used to display an image). The BLU may provide a light source for the liquid crystal display, so that subpixels (subpixels) in the liquid crystal display can emit light to display an image. Alternatively, in some other embodiments of this application, the display module 20 may be an organic light-emitting diode (organic light-emitting diode, OLED) display. Because an electroluminescent layer is disposed in each subpixel in the OLED display, the OLED display can achieve self light emission after receiving an operating voltage. In this case, the foregoing BLU does not need to be disposed in the display module 20 having the OLED display.

Based on the foregoing structure, the first structural member 111, the second structural member 112, and the display module 20 may enclose mounting space 101 for accommodating an electronic element, and the electronic element may include a sensor, a camera, a microphone, a battery, and the like. Certainly, the electronic element in the electronic device 1' is not limited to the foregoing several examples.

In some embodiments, the electronic device 1' may further include a mainboard 80 mounted in the mounting space 101 and a heat-generating element 81 mounted on the mainboard 80. The heat-generating element 81 may be a system on chip (system on chip, SoC), a central processing unit (central processing unit, CPU), or a graphics processing unit (graphics processing unit, GPU). The mainboard 80 may be a printed circuit board (printed circuit board, PCB). Other components such as a capacitor may be further mounted on the mainboard 80. This is not limited in this embodiment of this application. The mainboard 80 is electrically connected to a drive circuit in the display module 20, so that a processor on the PCB can control the display module 20 to display an image.

On this basis, to ensure heat dissipation efficiency of the heat-generating element 81, a heat dissipation technology employed by the electronic device 1' is mainly an air-cooling apparatus combining a heat dissipation assembly and a fan module 30'.

In some implementations, the heat dissipation assembly may be disposed on one side of the heat-generating element 81. The heat dissipation assembly may include a metal heat conducting plate 82 and a heat dissipation component 83. The metal heat conducting plate 82 may be located between the heat-generating element 81 and the heat dissipation component 83. The heat dissipation component 83 may be, for example, a heat dissipator with a vapor chamber (Vapor-Chamber, VC) heat dissipation technology. Through the foregoing arrangement, the heat dissipation component 83 can efficiently transfer heat generated by the heat-generating element 81 to the mounting space 101, so that an excessively high temperature of the heat-generating element 81 is avoided.

In some implementations, as shown in FIG. 1, the electronic device 1' may further include the fan module 30'. FIG. 2 is a diagram of a structure of the fan module 30' according to some embodiments. With reference to FIG. 2, the fan module 30' may include a fan casing 32 and a fan body 31. The fan casing 32 may enclose the exterior of the fan body 31, so that the fan casing 32 can protect the fan body 31. The fan casing 32 is provided with an air inlet opening M and an air outlet opening N. The air inlet opening M may communicate with the mounting space 101, and the air outlet opening N communicates with an external environment. Through the foregoing arrangement, airflow carrying heat may enter the fan casing 32 through the air inlet opening M of the fan casing 32, and be discharged into external space through the air outlet opening N, to transfer the heat from the heat dissipation assembly to the outside of the electronic device 1'.

In some embodiments, the fan module 30' may be mounted in the mounting space 101. For example, an air intake vent of the fan casing 32 may be located on a side that is of the air intake vent of the fan casing 32 and that is close to the display module 20, so that there is a specific spacing (that is, d2 in FIG. 1) between the fan module 30' and the display module 20. Based on the foregoing structure, the fan casing 32 may be connected to the first structural member 111 through threaded fasteners such as a bolt, so that there is further a specific assembly spacing (that is, d4 in FIG. 1) between the fan casing 32 and the first structural member 111.

To ensure heat dissipation efficiency in the electronic device 1', a thickness (that is, d3 in FIG. 1) of the fan module 30' disposed in the electronic device 1' usually needs to be ensured, and a spacing (that is, d2 in FIG. 1) between the display module 20 and the fan module 30' needs to be further ensured as well. A thickness of the electronic device 1' may be a sum of a thickness (that is, d1 in FIG. 1) of the display module 20, the spacing (that is, d2 in FIG. 1) between the display module 20 and the fan module 30', the thickness (that is, d3 in FIG. 1) of the fan module 30', the spacing (that is, d4 in FIG. 1) between the fan module 30' and the first structural member 111, and a thickness (that is, d5 in FIG. 1) of the first structural member 111. However, in the foregoing mounting manner of the fan module 30', the electronic device 1' is thick. As a result, it is difficult to ensure a light weight and thinning of the electronic device 1'. Herein, the "thickness" may be understood as a dimension in a direction perpendicular to the display surface of the display module 20.

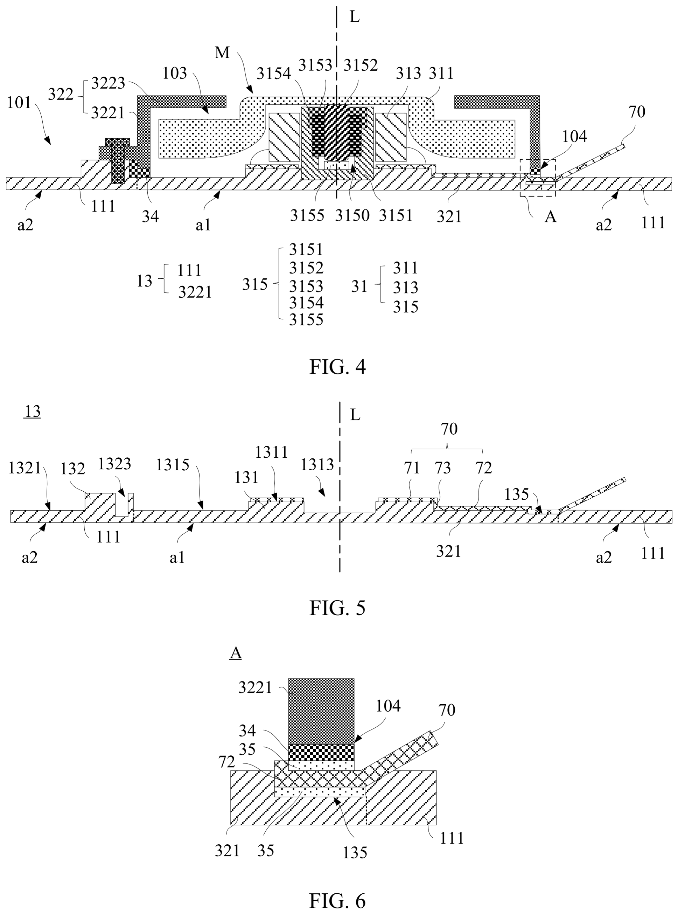

FIG. 3 is a diagram of a structure of an electronic device 1 according to an embodiment of this application. FIG. 4 is a cross-sectional view of a fan module 30 according to an embodiment of this application. Refer to FIG. 3 and FIG. 4. In view of this, in the electronic device 1 provided in this embodiment of this application, a fan casing 32 may include a first portion 321 and a second portion 322. The first portion 321 is connected to a first structural member 111, and the first portion 321 and the first structural member 111 jointly form a flat plate structure 13. Herein, the "flat plate structure 13" may be used as a main unit appearance board of the electronic device 1, or may be used as a part of a middle frame of a main unit. Herein, "the first portion 321 and the first structural member 111 jointly form the flat plate structure 13" may be understood as follows: The first portion 321 and the first structural member 111 are integrally formed, and an integrally formed structure is the flat plate structure 13; or the first portion 321 is connected to the first structural member 111, so that the first portion 321 and the first structural member 111 that are connected together jointly form the flat plate structure 13, and there may be a specific assembly gap or an assembly step difference between the first portion 321 and the first structural member 111. For example, the first portion 321 may be approximately a flat plate, and a structure of the first structural member 111 may also be approximately a flat plate. Two flat plates are connected together, so that the first portion 321 and at least a part of the first structural member 111 jointly form the flat plate structure 13.

Still refer to FIG. 3. The flat plate structure 13 and a second structural member 112 may jointly enclose mounting space 101, a fan body 31 may be located in the mounting space 101, and the second portion 322 is located in the mounting space 101. For example, the flat plate structure 13 and the second structural member 112 jointly enclose a groove, and space in the groove is the mounting space 101. In an embodiment in which the electronic device 1 further includes a display module 20, the display module 20 may block the groove. In other words, the display module 20, the flat plate structure 13, and the second structural member 112 jointly enclose the mounting space 101.

Refer to FIG. 4. The first portion 321 includes a first surface a1. The first structural member 111 includes a second surface a2. The first surface a1 and the second surface a2 are located on a side that is of the flat plate structure 13 and that is away from the mounting space 101. The second surface a2 and the first surface a1 are located on a same plane. Herein, "the second surface a2 and the first surface a1 are located on the same plane" may be understood as follows: A part of the second surface a2 and the first surface a1 may be located on a same plane; a part of the second surface a2 and a part of the first surface a1 are located on a same plane; or the second surface a2 and a part of the first surface a1 are located on a same plane. Herein, the "plane" may be understood as an absolutely flat surface or an approximately flat surface, the approximately flat surface may slightly fluctuate, and an acceptable deviation range of the approximately flat surface may be, for example, a deviation within 5%. Through the foregoing arrangement, the first portion 321 and the first structural member 111 form the flat plate structure 13. This helps reduce an assembly spacing (that is, d4 in FIG. 1) between the fan casing 32 and the first structural member 111, and reduce space occupied by the fan casing 32 in the mounting space 101, thereby helping reduce a thickness of the electronic device 1 and achieving a light weight and thinning of the electronic device 1.

In this embodiment of this application, with reference to FIG. 2 and FIG. 4, the second portion 322 may include a frame 3221 and a cover plate 3223. The frame 3221 may be located between the first portion 321 and the cover plate 3223. The frame 3221 is disposed around an edge of the cover plate 3223. For example, the frame 3221 may be disposed around an edge of the first portion 321, so that the first portion 321, the frame 3221, and the cover plate 3223 enclose accommodation space 103, and the fan body 31 is located in the accommodation space 103.

With reference to FIG. 2 and FIG. 4, the second portion 322 is connected to a part of the first portion 321 in a sealed manner, the second portion 322 is provided with an air inlet opening M, and the second portion 322 and the first portion 321 enclose an air outlet opening N. For example, the first portion 321 and the cover plate 3223 may be approximately a circular flat plate, the first portion 321 is provided opposite the cover plate 3223, and the frame 3221 may be disposed around a part of edges of the first portion 321 and the cover plate 3223. In other words, the frame 3221, the first portion 321, and the cover plate 3223 may jointly enclose an opening, and the opening is the air outlet opening N. In addition, the air inlet opening M may be provided on the cover plate 3223. Through the foregoing arrangement, air in the mounting space 101 may enter the accommodation space 103 through the air inlet opening M, and be blown to an external environment through the air outlet opening N. The second portion 322 is connected to the part of the first portion 321 in a sealed manner. This helps the second portion 322 and the part of the first portion 321 form a sealed air outlet channel, thereby preventing air backflow, and improving a heat dissipation capability of a fan assembly.

Still refer to FIG. 4. The fan body 31 may include a shaft base 315, fan blades 311, and a stator assembly 313. The shaft base 315 is connected to the first portion 321. The stator assembly 313 is connected to the shaft base 315. The fan blade 311 is rotatably connected to the shaft base 315.

For example, the shaft base 315 may include a mounting base 3151, a rotation shaft 3152, and a rotation bearing 3153. The mounting base 3151 may be mounted on the first portion 321. One end that is of the mounting base 3151 and that is away from the first portion 321 is provided with a groove 3150. The rotation shaft 3152 and the rotation bearing 3153 are located in the groove 3150, and the rotation bearing 3153 is connected between the rotation shaft 3152 and a groove wall of the groove 3150. For example, the rotation shaft 3152 may be in interference fit with an inner ring of the rotation bearing 3153, and the groove wall of the groove 3150 may be in interference fit with an outer ring of the rotation bearing 3153. Through the foregoing arrangement, the rotation shaft 3152 is rotatable relative to the mounting base 3151.

In some embodiments, the shaft base 315 may further include a wear-resistant pad 3155, and the wear-resistant pad 3155 is located between the rotation shaft 3152 and a groove bottom of the groove 3150. A material of the wear-resistant pad 3155 may include, for example, peek (polyether ether ketone). The wear-resistant pad 3155 is disposed, to help prevent the rotation shaft 3152 from wearing the mounting base 3151. In some embodiments, the shaft base 315 may further include an oil seal cover 3154, and the oil seal cover 3154 is connected between the rotation shaft 3152 and the mounting base 3151 in a sealed manner. It may be understood that the groove 3150 is usually filled with lubricating oil or lubricating grease, to reduce frictional resistance in a rotation process of the rotation shaft 3152. The oil seal cover 3154 is disposed, to help prevent the lubricating oil or the lubricating grease in the groove 3150 from leaking, thereby avoiding contamination of the fan body 31.

In some embodiments, the stator assembly 313 may be, for example, a stator coil, and the stator coil may cover the shaft base 315. Correspondingly, the electronic device 1 may further include a circuit board 70, and the circuit board 70 is located in the mounting space 101. Correspondingly, the fan casing 32 may further include a communication hole 104, and the circuit board 70 extends into the mounting space 101 through the communication hole 104 and is electrically connected to the stator assembly 313. In addition, with reference to FIG. 1, the circuit board 70 may be further electrically connected to the mainboard 80 in the electronic device 1'. For example, the circuit board 70 may be electrically connected to the stator assembly 313 through a metal lead. Through the foregoing arrangement, the mainboard 80 may control the circuit board 70 to supply power to the stator coil, and after the stator coil is energized, a rotating electromagnetic field is generated.

Based on the foregoing structure, the fan blade 311 may be connected to the rotation shaft 3152, and the fan blade 311 includes a magnetic element, so that the fan blade 311 is rotatable relative to the shaft base 315. For example, a central axis of the rotation shaft 3152 may be a rotation axis L of the fan blade 311. The fan blade 311 may include a plurality of blades. The blade may be a forward-curved blade. Alternatively, the blade may be a backward-curved blade. The magnetic element may be, for example, a permanent magnetic ring. When the stator coil is energized, the permanent magnetic ring and the rotating electromagnetic field repel and drive each other, so that when the fan blade 311 rotates relative to the shaft base 315, air in the mounting space 101 enters the accommodation space 103 through the air inlet opening M, and airflow flows to the air outlet opening N under the driving of the blade, and is discharged from the air outlet opening N.

It may be understood that shapes of the shaft base 315 and the stator coil may be designed according to an actual motion requirement of the fan blade 311. This is not limited in this embodiment of this application. In addition, the fan body 31 may further include another structure, and a driving manner of the fan blade 311 is not limited to mutual repulsion and drive between magnetic elements. A specific structure of the fan body 31 and a driving manner of the fan blade 311 are not limited in this embodiment of this application.

FIG. 5 is a cross-sectional view of the flat plate structure 13 in electronic device 1 in FIG. 4. With reference to FIG. 4 and FIG. 5, in some embodiments, a protrusion structure 131 is provided on a side that is of the first portion 321 and that is close to the mounting space 101. A first sub-surface 1311 is provided on a side that is of the protrusion structure 131 and that is close to the mounting space 101. The first sub-surface 1311 is provided opposite to the first surface a1. The first sub-surface 1311 is recessed toward a side close to the first surface a1 to form a mounting groove 1313. The shaft base 315 is mounted in the mounting groove 1313. For example, the protrusion structure 131 may be approximately a cylindrical structure, and an upper surface of the cylindrical structure is the first sub-surface 1311. A shape of the mounting groove 1313 may be correspondingly disposed based on a shape of the mounting base 3151 of the shaft base 315, so that the mounting base 3151 of the shaft base 315 may be mounted in the mounting groove 1313. In some examples, a material of the mounting base 3151 may include metal, for example, copper, aluminum, or stainless steel. For example, when the first portion 321 and the mounting base 3151 are both made of metal, the mounting base 3151 may be riveted to the mounting groove 1313 of the first portion 321, and glue is added between the mounting base 3151 and the mounting groove 1313, to further increase connection strength between the mounting base 3151 and the first portion 321. Through the foregoing arrangement, the fan body 31 may be mounted on the first portion 321 through the protrusion structure 131, and connection strength of the fan body 31 is improved by partially increasing a thickness of the first portion 321.

In some embodiments, the first sub-surface 1311 may be parallel to the first surface a1 and perpendicular to the rotation axis L of the fan blade 311. For example, the fan blade 311 is rotatable relative to the rotation shaft 3152, and a center line of the rotation shaft 3152 is the rotation axis L of the fan blade 311. The first sub-surface 1311 may be perpendicular to the center line of the rotation shaft 3152. In other words, the first sub-surface 1311 may be perpendicular to the rotation axis L of the fan blade 311. Through the foregoing arrangement, interference between the fan blade 311 in a rotation process and the first sub-surface 1311 is avoided. This helps reduce scratches of the fan blade 311.

In some examples, flatness of the first sub-surface 1311 may be less than or equal to 0.2 mm. For example, the flatness of the first sub-surface 1311 may be 0.1 mm, 0.15 mm, or 0.2 mm. Herein, the "flatness" may be understood as a deviation value of an uneven height of an actual plane of the first sub-surface 1311 relative to a desirable plane. The flatness of the first sub-surface 1311 is limited, to help further improve flatness effect of the first sub-surface 1311, and further avoid the interference between the fan blade 311 in the rotation process and the first sub-surface 1311.

In some embodiments, the first portion 321 may further include a second sub-surface 1315 adjacent to the protrusion structure 131. The second sub-surface 1315 is provided opposite to the first surface a1. The second sub-surface 1315 is parallel to the first surface a1 and is perpendicular to the rotation axis L of the fan blade 311. For example, the second sub-surface 1315 may surround an edge of the protrusion structure 131. A distance between the second sub-surface 1315 and the first surface a1 is shorter than a distance between the first sub-surface 1311 and the first surface a1. Through the foregoing arrangement, the interference between the fan blade 311 in the rotation process and the first sub-surface 1311 is avoided. This helps reduce scratches of the fan blade 311. In addition, the foregoing arrangement further helps ensure a size of the mounting space 101 enclosed by the first portion 321, the first structural member 111, and the second structural member 112, and increase the mounting space 101.

In some examples, flatness of the second sub-surface 1315 may be less than or equal to 0.2 mm. For example, the flatness of the second sub-surface 1315 may be 0.1 mm, 0.15 mm, or 0.2 mm. Herein, the "flatness" may be understood as a deviation value of an uneven height of an actual plane of the second sub-surface 1315 relative to a desirable plane. The flatness of the second sub-surface 1315 is limited, to help further improve flatness effect of the second sub-surface 1315, and further avoid interference between the fan blade 311 in the rotation process and the second sub-surface 1315.

In some embodiments, a third sub-surface 1321 may be provided on a side that is of the first structural member 111 and that is close to the mounting space 101. The third sub-surface 1321 is provided opposite to the second surface a2. At least a part of the third sub-surface 1321 and at least a part of the second sub-surface 1315 are located on a same plane. Herein, "at least the part of the third sub-surface 1321 and at least the part of the second sub-surface 1315 are located on the same plane" may be understood as follows: A part of the third sub-surface 1321 and the second sub-surface 1315 may be located on a same plane; a part of the third sub-surface 1321 and a part of the second sub-surface 1315 are located on a same plane; or the third sub-surface 1321 and a part of the second sub-surface 1315 are located on a same plane. Herein, the "plane" may be understood as an absolutely flat surface or an approximately flat surface, the approximately flat surface may slightly fluctuate, and an acceptable deviation range of the approximately flat surface may be, for example, a deviation within 5%.

As described in the foregoing embodiment, the second sub-surface 1315 may be parallel to the first surface a1. At least the part of the third sub-surface 1321 and at least the part of the second sub-surface 1315 are located on the same plane, at least a part of the first surface a1 and at least a part of the second surface a2 are located on a same plane, and at least the part of the third sub-surface 1321 may be parallel to the second surface a2. Therefore, this helps improve regularity of the first structural member 111, further ensure the size of the mounting space 101 enclosed by the first portion 321, the first structural member 111, and the second structural member 112, and increase the mounting space 101.

In some examples, flatness of the third sub-surface 1321 may be less than or equal to 0.2 mm. For example, the flatness of the third sub-surface 1321 may be 0.1 mm, 0.15 mm, or 0.2 mm. Herein, the "flatness" may be understood as a deviation value of an uneven height of an actual plane of the third sub-surface 1321 relative to a desirable plane. The flatness of the third sub-surface 1321 is limited, to help further improve flatness effect of the third sub-surface 1321, and further improve the regularity of the first structural member 111.

Based on the foregoing structure, the circuit board 70 may include a first plate portion 71, a second plate portion 72, and a bent portion 73. The first plate portion 71 may be connected to the first sub-surface 1311. The second plate portion 72 may be connected to the second sub-surface 1315. The bent portion 73 may be connected between the first plate portion 71 and the second plate portion 72. For example, the circuit board 70 may be a flexible circuit board 70 (Flexible Printed Circuit, FPC), the first plate portion 71 may be bonded to the first sub-surface 1311, the second plate portion 72 may be bonded to the second sub-surface 1315, and the bent portion 73 may be bonded to a peripheral surface of the protrusion structure 131 and is connected between the first plate portion 71 and the second plate portion 72. Through the foregoing arrangement, the circuit board 70 can be mounted on the first portion 321, and further, space occupied by the circuit board 70 in the mounting space 101 can be reduced. In addition, the second plate portion 72 may further pass through the communication hole 104, so that the second plate portion 72 can extend out of the fan casing 32 through the communication hole 104 and is electrically connected to a mainboard 80 of the electronic device 1.

In some embodiments, still refer to FIG. 4. The first portion 321 and the first structural member 111 may be of an integrated structure. For example, the first portion 321 and the second structural member 112 may be an integrated metal plate. A material of the metal plate may include, for example, magnesium alloy and stainless steel. The first portion 321 and the first structural member 111 are disposed as the integrated structure, to help improve connection strength between the first portion 321 and the first structural member 111.

Planar-milled processing may be performed on a surface of the metal plate by using a computer numerical control (Computer numerical control, CNC) machine tool. For example, the second sub-surface 1315 of the first portion 321 and the third sub-surface 1321 of the first structural member 111 may be located on a same plane by using the planar-milled processing, and the plane is parallel to a plane on which the first surface al and the second surface a2 are located. In addition, the first sub-surface 1311 of the first portion 321 may be further parallel to the plane on which the first surface a1 and the second surface a2 are located by using the planar-milled processing, and a groove may be further milled on the first sub-surface 1311 by increasing a milling depth. In some implementations, flatness of the first sub-surface 1311, the second sub-surface 1315, and the third sub-surface 1321 that are obtained through milling may be adjusted by adjusting precision of the planar-milled processing.

As described in the foregoing embodiment, refer to FIG. 4. The second portion 322 may include the frame 3221 and the cover plate 3223. Based on the foregoing structure, the frame 3221 and the cover plate 3223 may be of an integrated structure. For example, the frame 3221 and the cover plate 3223 may be an integrated structure formed by press-fitting a same metal plate. The frame 3221 and the cover plate 3223 are disposed as the integrated structure, to help improve connection strength between the frame 3221 and the cover plate 3223, and further improve overall structural strength of the second portion 322. In addition, the frame 3221 and the cover plate 3223 are of an integrated structure. This helps further improve sealing performance between the frame 3221 and the cover plate 3223, and the second portion 322 and the part of the first portion 321 form the sealed air outlet channel, thereby preventing air backflow and improving the heat dissipation capability of the fan assembly.

In addition, when the frame 3221 and the cover plate 3223 are of an integrated metal structure, this helps reduce a thickness of the second portion 322 while ensuring the overall structural strength of the second portion 322, so that space occupied by the fan module 30 in the electronic device 1 is reduced, and space utilization in the electronic device 1 is improved.

In some embodiments, the frame 3221 is detachably connected to the side that is of the first structural member 111 and that is close to the mounting space 101. For example, with reference to FIG. 4 and FIG. 5, a mounting boss 132 is provided on the side that is of the first structural member 111 and that is close to the mounting space 101, and the mounting boss 132 may be threadedly connected to the frame 3221. For example, the mounting boss 132 may be provided on the third sub-surface 1321 of the first structural member 111, the mounting boss 132 may be provided with a counterbore 1323, and a hole wall of the counterbore 1323 may have an inner thread. Correspondingly, the frame 3221 may further have a threaded hole provided opposite to the counterbore 1323, and threaded fasteners such as a bolt may pass through the threaded hole and the counterbore 1323, so that the mounting boss 132 is threadedly connected to the frame 3221. Through the foregoing arrangement, a detachable connection between the frame 3221 and the first structural member 111 can be implemented, and this facilitates replacement or repair the fan body 31 at any time.

Certainly, in this embodiment of this application, the frame 3221 and the cover plate 3223 may alternatively be two independent structures, and the frame 3221 and the cover plate 3223 may be connected together in a welding or bonding manner.

Based on the foregoing structure, refer to FIG. 4. The fan module 30 may further include a sealing structure 34, and the sealing structure 34 may be located between the first portion 321 and the frame 3221. The sealing structure 34 may include a sealing ring, sealant, and the like. As described in the foregoing embodiment, the frame 3221 may be disposed around the part of edges of the first portion 321 and the cover plate 3223. Correspondingly, the sealing structure 34 may also be disposed around a part of edges of the first portion 321 and the frame 3221, so that the frame 3221 is connected to the part of the first portion 321 in a sealed manner. This helps the second portion 322 and the part of the first portion 321 form the sealed air outlet channel, thereby preventing air backflow and improving the heat dissipation capability of the fan assembly.

FIG. 6 is a partial enlarged view at a position A in the electronic device 1 in FIG. 4. As shown in FIG. 6, in some embodiments, a recessed structure 135 is further provided on the side that is of the first portion 321 and that is close to the mounting space 101, and the recessed structure 135 and the frame 3221 jointly enclose the communication hole 104. A part of the second sub-surface 1315 may be recessed in a direction close to the first surface a1 to form the recessed structure 135. For example, a groove may be milled on the part of the second sub-surface 1315 by using the planar-milled processing, and the groove is the recessed structure 135. As described in the foregoing embodiment, the second plate portion 72 of the circuit board 70 may further be bent in a direction close to the recessed structure 135, and pass through the communication hole 104. Through the foregoing arrangement, the circuit board 70 may extend into the fan casing 32 through the communication hole 104 and be electrically connected to the stator assembly 313.

As described in the foregoing embodiment, the sealing structure 34 is located between the frame 3221 and the first portion 321. A part of the sealing structure 34 may be located between the frame 3221 and the recessed structure 135. To be specific, the part of the sealing structure 34 may be located in the communication hole 104, and the circuit board 70 may be located between the sealing structure 34 and the recessed structure 135. Through the foregoing arrangement, sealing effect between the circuit board 70 and the frame 3221 is improved. In addition, in comparison with arrangement of the circuit board 70 between the sealing structure 34 and the frame 3221, arrangement of the circuit board 70 between the sealing structure 34 and the recessed structure 135 helps prevent the frame 3221 from crushing the circuit board 70.

In some examples, the fan module 30 may further include a sealing layer 35. The sealing layer 35 may be located between the second plate portion 72 of the circuit board 70 and the recessed structure 135, and between the second plate portion 72 of the circuit board 70 and the sealing structure 34. A material of the sealing layer 35 may include, for example, foam. The sealing layer 35 is disposed, to help further improve sealing effect between the circuit board 70 and the communication hole 104, and the second portion 322 and the part of the first portion 321 form the sealed air outlet channel, thereby preventing air backflow and improving the heat dissipation capability of the fan assembly.

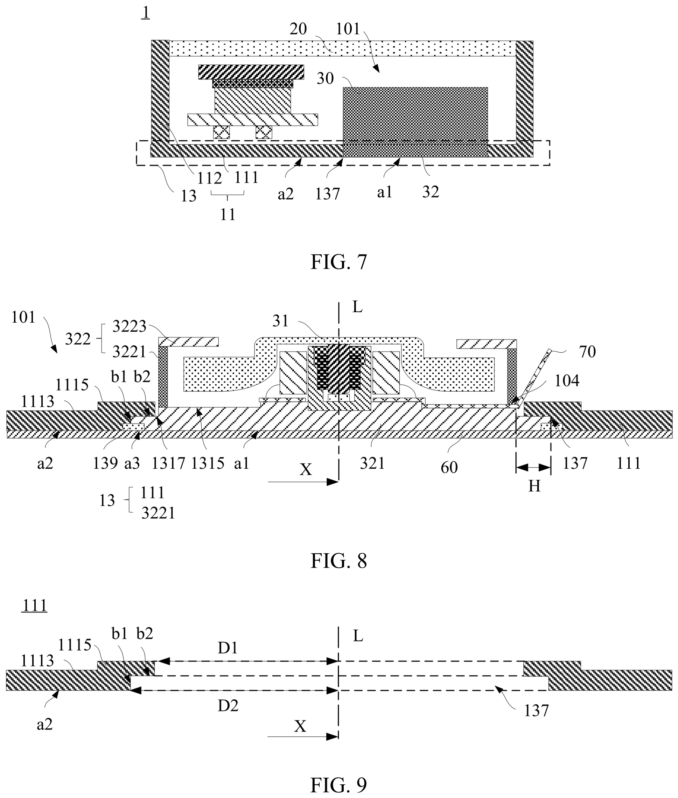

FIG. 7 is a diagram of a structure of another electronic device 1 according to an embodiment of this application. FIG. 8 is a diagram of a structure of another fan module 30 according to an embodiment of this application. As shown in FIG. 7 and FIG. 8, in some embodiments, a first structural member 111 may be provided with a mounting opening 137 that runs through the first structural member 111, and at least a part of a first portion 321 may be located in the mounting opening 137. A shape of the mounting opening 137 may be correspondingly disposed based on a shape of the first portion 321. For example, the mounting opening 137 may be a circular opening, and correspondingly, a cross-sectional shape of the first portion 321 in a plane parallel to a first surface a1 may be a circle, so that at least a part of the first portion 321 may be located in the mounting opening 137. Herein, "at least the part of the first portion 321 may be located in the mounting opening 137" may be understood as follows: When a thickness of the first portion 321 is less than or equal to a thickness of the first structural member 111, the first portion 321 is located in the mounting opening 137; or when a thickness of the first portion 321 is greater than a thickness of the first structural member 111, a part of the first portion 321 protrudes from the mounting opening 137, and a part of the first portion 321 is located in the mounting opening 137.

Based on the foregoing structure, in a process of mounting the fan module 30 in this embodiment of this application, a fan body 31 may be first mounted in a fan casing 32, the fan casing 32 is mounted on the first structural member 111, and the first portion 321 is located in the mounting opening 137 of the first structural member 111, so that the first portion 321 and the first structural member 111 jointly form a flat plate structure 13. The first portion 321 and the first structural member 111 may be welded together. Alternatively, the first portion 321 and the first structural member 111 may be bonded together. A connection manner between the first portion 321 and the first structural member 111 is not specifically limited in this embodiment of this application.

In conclusion, at least the part of the first portion 321 may be located in the mounting opening 137, so that the first structural member 111 and the first portion 321 jointly form the flat plate structure 13. This helps reduce an assembly spacing between the fan casing 32 and the first structural member 111, and reduce a thickness of a part of the first structural member 111, thereby helping reduce a thickness of the electronic device 1 and achieving a light weight and thinning of the electronic device 1.

As shown in FIG. 8, in this embodiment of this application, a frame 3221 and a cover plate 3223 in a second portion 322 may be two independent structures, and may be sequentially assembled on the first portion 321, to form the fan casing 32. For example, the frame 3221 may be formed on the first portion 321 by using an injection molding process, and the frame 3221 is disposed around an edge of the first portion 321. There is good sealing performance and connection strength between the frame 3221 formed by using the injection molding process and the first portion 321. After the frame 3221 is formed, the cover plate 3223 may be bonded to a side that is of the frame 3221 and that is away from the first portion 321, to form the fan casing 32. When the frame 3221 is formed on the first portion 321 by using the injection molding process, a structure of an injection mold may be adjusted, so that the formed frame 3221 is provided with a communication hole 104, and a circuit board 70 extends into the fan casing 32 through the communication hole 104 and is electrically connected to a stator assembly 313.

Certainly, in some other implementations, the frame 3221 and the cover plate 3223 may alternatively be of an integrated structure. This is not specifically limited in this embodiment of this application.

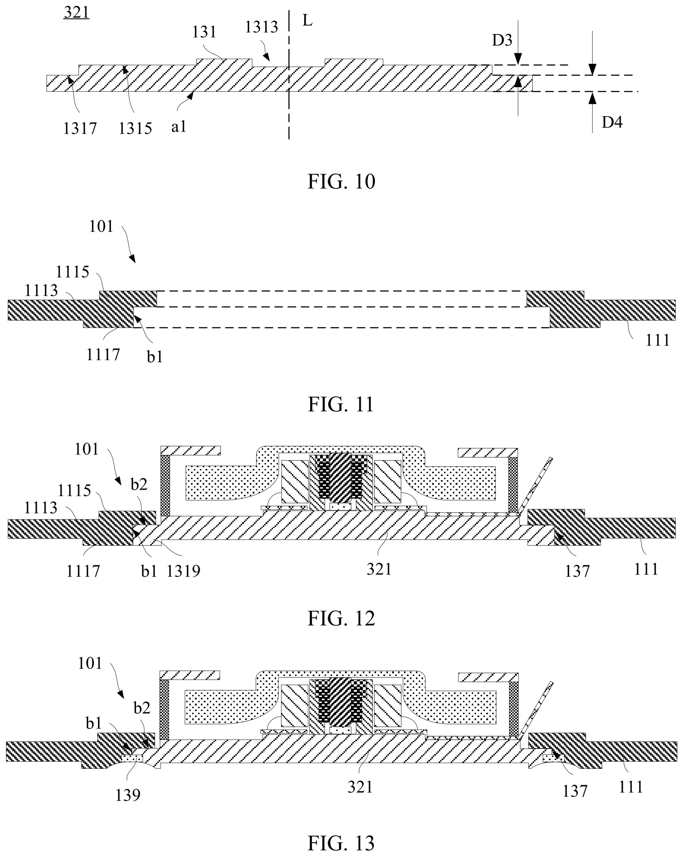

FIG. 9 is a cross-sectional view of the first structural member 111 in the electronic device 1 in FIG. 8. FIG. 10 is a cross-sectional view of the first portion 321 in the electronic device 1 in FIG. 8. With reference to FIG. 8, FIG. 9, and FIG. 10, in some embodiments, the first structural member 111 may include a bottom plate 1113 and a lapping block 1115. The bottom plate 1113 is provided with a mounting opening 137 that runs through the bottom plate 1113. A second surface a2 is provided on a side that is of the bottom plate 1113 and that is away from the mounting space 101. The bottom plate 1113 is further provided with a side surface b1 adjacent to the second surface a2. The side surface b1 encloses the mounting opening 137. The lapping block 1115 is connected to a side that is of the bottom plate 1113 and that is close to the mounting space 101. In a direction (for example, an X direction in FIG. 9) that is parallel to the second surface a2 and that points from the side surface b1 to a rotation axis L of a fan blade 311, the lapping block 1115 extends beyond the side surface b1.

For example, a bottom surface of the bottom plate 1113 may be the second surface a2, a top surface of the bottom plate 1113 is the side surface that is of the bottom plate 1113 and that is close to the mounting space 101, and the lapping block 1115 may be connected to the top surface of the bottom plate 1113. The mounting opening 137 may be a circular opening. In other words, the side surface b1 that encloses the mounting opening 137 may be an annular surface. Correspondingly, a cross-sectional shape of the lapping block 1115 parallel to the second surface a2 may be an annular shape, a central axis of the lapping block 1115 may coincide with a central axis of the mounting opening 137, and the central axis of the mounting opening 137 may further coincide with the rotation axis L of the fan blade 311. In the direction (for example, the X direction in FIG. 9) that is parallel to the second surface a2 and that points from the side surface b1 to the rotation axis L of the fan blade 311, a distance D1 between the lapping block 1115 and the rotation axis L of the fan blade 311 is shorter than a distance D2 between the side surface b1 and the rotation axis L of the fan blade 311, so that the lapping block 1115 extends beyond the side surface b1.

Based on the foregoing arrangement, a surface that is of the lapping block 1115 and that is adjacent to the side surface b1 is a lapping surface b2, and the lapping surface b2 is in contact with a side that is of the first portion 321 and that is close to the mounting space 101. For example, the first portion 321 may further include a fourth sub-surface 1317, and the fourth sub-surface 1317 is located on the side that is of the first portion 321 and that is close to the mounting space 101, and is located on a side that is of a second sub-surface 1315 and that is away from a first sub-surface 1311. The fourth sub-surface 1317 may be parallel to the first surface a1, and a distance D4 between the fourth sub-surface 1317 and the first surface a1 may be shorter than a distance D3 between the second sub-surface 1315 and the first surface a1. The fourth sub-surface 1317 may be in contact with the lapping block 1115, so that the lapping block 1115 can limit the first portion 321, and the first portion 321 does not move in a direction close to the mounting space 101.

In addition, because the lapping block 1115 is connected to the side that is of the bottom plate 1113 and that is close to the mounting space 101, during mounting of the fan casing 32, the fan casing 32 may be extended into the mounting space 101 from the outside of a housing 11, and the first portion 321 made in contact with the lapping surface b2, to facilitate mounting and fastening of the fan casing 32.

Certainly, in some other embodiments, the fourth sub-surface 1317 may be omitted in the first portion 321, and the second sub-surface 1315 of the first portion 321 is in contact with the lapping block 1115. Alternatively, in some other embodiments, the lapping block 1115 may be further connected to the second surface a2 of the bottom plate 1113. This is not specifically limited in this embodiment of this application.

In some embodiments, still refer to FIG. 8. A part of the bottom plate 1113 and a part of the first portion 321 jointly form a welding block 139, a third surface a3 is provided on a side that is of the welding block 139 and that is away from the mounting space 101, and at least a part of the third surface a3, at least a part of the first surface a1, and at least a part of the second surface a2 are located on a same plane. For example, materials of the bottom plate 1113 and the first portion 321 may include metal, and a part of the second surface a2 of the bottom plate 1113 and a part of the first surface a1 of the first portion 321 are welded together by using a welding process, so that the part of the bottom plate 1113 and the part of the first portion 321 jointly form the welding block 139. Through the foregoing arrangement, the bottom plate 1113 and the first portion 321 are welded together. This helps improve connection strength between the bottom plate 1113 and the first portion 321. In addition, the third surface a3 of the welding block 139 may be formed by welding the part of the second surface a2 of the bottom plate 1113 to the part of the first surface a1 of the first portion 321. Therefore, an operation may be performed outside of the housing 11 in a welding process. This helps increase operation space for the welding process and reduce a welding difficulty. In addition, at least the part of the third surface a3, at least the part of the first surface a1, and at least the part of the second surface a2 are located on the same plane. This helps further improve flatness of the housing 11, and improve aesthetics of the housing 11.

In some embodiments, in the direction (for example, an X direction in FIG. 8) that is parallel to the second surface a2 and that points from the side surface b1 to the rotation axis L of the fan blade 311, there is a preset distance H between the frame 3221 and the side surface b1. It may be understood that, in a process of welding the bottom plate 1113 and the first portion 321 together, a contact surface between the bottom plate 1113 and the first portion 321 is usually welded. Based on the description in the foregoing embodiment, that is, the side surface b1 of the bottom plate 1113 and a peripheral surface of the first portion 321 are welded. The preset distance H between the frame 3221 and the side surface b1 is adjusted, to help ensure a distance between a welding position and the frame 3221, avoid impact of a high temperature on the frame 3221 in the welding process, and improve structural reliability of the frame 3221.

For example, in the direction (for example, the X direction in FIG. 8) that is parallel to the second surface a2 and that points from the side surface b1 to the rotation axis L of the fan blade 311, the preset distance H between the frame 3221 and the side surface b1 may be greater than or equal to 10 cm. For example, the preset distance H between the frame 3221 and the side surface b1 may be 10 cm, 12 cm, or 14 cm. When the preset distance H approaches 10 cm, a size of the fan module 30 is improved, and heat dissipation performance of the electronic device 1 is ensured. However, as the preset distance H increases, impact of the welding process on the frame 3221 is smaller. This helps further improve reliability of the frame 3221. In addition, a volume occupied by the fan module 30 in the mounting space 101 is smaller, to help improve space utilization of the mounting space 101. In some embodiments, the electronic device 1 may further include a decoration layer 60, and the decoration layer 60 may be located on a side that is of the bottom plate 1113 and the first portion 321 and that is away from the mounting space 101. For example, the decoration layer 60 may be a laminated structure bonded to the bottom plate 1113 and the first portion 321. Alternatively, the decoration layer 60 may be a coating structure sprayed on surfaces of the bottom plate 1113 and the first portion 321. The decoration layer 60 is disposed, to help improve appearance aesthetics of the electronic device 1. In an embodiment in which the part of the bottom plate 1113 and the part of the first portion 321 jointly form the welding block 139, the decoration layer 60 further covers the welding block 139, to prevent the welding block 139 from being exposed. This helps further improve the aesthetics of the electronic device 1.

Refer to FIG. 11 to FIG. 14. The following briefly describes a process of mounting the first portion 321 of the fan casing 32 and the first structural member 111 of the housing 11 in embodiments of this application.

FIG. 11 is a cross-sectional view of a first structural member 111 present before welding according to an embodiment of this application. As shown in FIG. 11, a bottom plate 1113 of the first structural member 111 is further provided with a first welding boss 1117 protruding from a side away from a mounting space 101, the first welding boss 1117 may be adjacent to a side surface b1, and surface that is of the first welding boss 1117 and that faces a mounting opening 137 may be coplanar with the side surface b1.

FIG. 12 is a cross-sectional view of a structure obtained by lapping the first portion 321 over the first structural member 111 according to an embodiment of this application. Correspondingly, as shown in FIG. 12, the first portion 321 is further provided with a second welding boss 1319 protruding from the side away from the mounting space 101, and the second welding boss 1319 is in contact with the first welding boss 1117.

FIG. 13 is a cross-sectional view of a structure obtained by welding the first portion 321 to the first structural member 111 according to an embodiment of this application. As shown in FIG. 13, a contact surface between the first structural member 111 and the first portion 321 may be welded by using an automated laser welding process, so that the first structural member 111 and the first portion 321 are connected together. For example, after welding, the first welding boss 1117 and the second welding boss 1319 are recessed in a direction close to the mounting space 101. The automated laser welding process has advantages such as fast welding speed, a uniform weld seam, and no cracking. During automated laser welding, if a welding seam is slightly deformed, residual welding stress can be removed by laser engraving. Certainly, in this embodiment of this application, the first structural member 111 and the first portion 321 may be welded together by using another welding process. This is not specifically limited in this embodiment of this application.

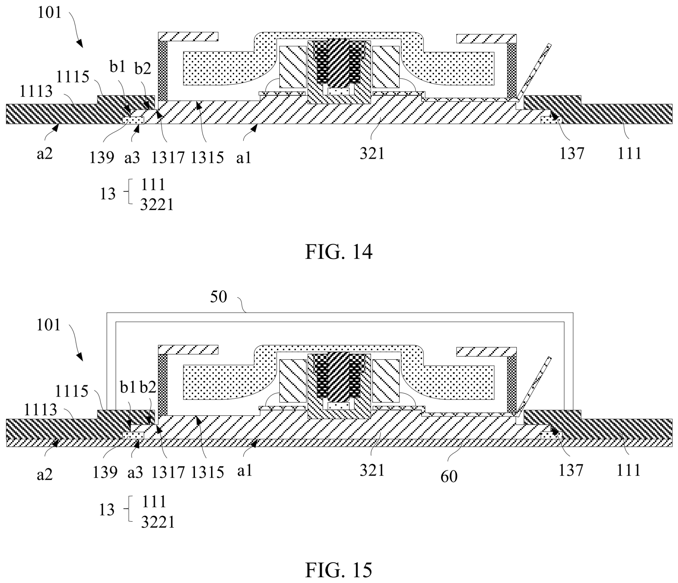

FIG. 14 is a cross-sectional view of a structure obtained by grinding the first portion 321 and the first structural member 111 according to an embodiment of this application. As shown in FIG. 14, after the first structural member 111 and the first portion 321 are welded together, the first structural member 111 and the side surface b1 that is of the first portion 321 and that is away from the mounting space 101 may be ground to form a first surface a1, a second surface a2, and a third surface a3 that are located on a same plane. The first surface a1 is a surface that is of the first portion 321 and that is away from the mounting space 101, the second surface a2 is a surface that is of the first structural member 111 and that is away from the mounting space 101, and the third surface a3 is a surface that is of a welding block 139 and that is away from the mounting space 101.

In some examples, a plurality of times of grinding may be performed to ensure flatness of the first surface a1, the second surface a2, and the third surface a3. For example, a 1^{st} grinding operation may be performed first, and oxides on surfaces of the first welding boss 1117, the second welding boss 1319, the first structural member 111, and the first portion 321 are removed by using a coarse grinding wheel. After the 1^{st} grinding operation is performed, a 2^{nd} grinding operation may be performed, and the first structural member 111, the welding block 139, and the first portion 321 are ground to a flat finish by using a fine grinding wheel. After the 2^{nd} grinding operation is performed, a 3^{rd} grinding operation may be performed, and the surfaces may be finely ground by using a grinding wheel.

FIG. 15 is a cross-sectional view of a structure obtained by spraying a decoration layer 60 on surfaces of the first portion 321 and the first structural member 111 according to an embodiment of this application. As shown in FIG. 15, after the first structural member 111 and the side surface b1 that is of the first portion 321 and that is away from the mounting space 101 are ground, the decoration layer 60 may be formed by using a spraying process. A plurality of times of spraying may be performed to ensure reliability of the decoration layer 60. For example, a primer coating, an intermediate coating, and a paint coating may be sequentially sprayed by using three spraying processes. The primer coating is used to enhance adhesion of the decoration layer 60, the intermediate coating is used to implement coloring effect, and the paint coating is used to achieve protection effect.

In some embodiments, still refer to FIG. 15. In a process of assembling the first structural member 111 and the first portion 321, a protective cover 50 may further enclose a fan module 30. The protective cover 50 is connected to a side that is of the first structural member 111 and that is close to the mounting space 101, and encloses the exterior of a second portion 322 of the fan casing 32. For example, the protective cover 50 may include a cover body, the cover body is provided with a vacuum cavity, and a material of the cover body may be metals such as stainless steel. Through the foregoing arrangement, in a process of forming the decoration layer 60 by using the spraying process, paint splashing on the second portion 322 can be avoided. In addition, in a process of welding the first structural member 111 and the first portion 321 together by using a welding process, the protective cover 50 may also be used. This helps to prevent a baking temperature from affecting performance of the second portion 322 and a fan body 31, and improve reliability of the fan module 30.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A fan module, comprising:
a housing, comprising a first structural member and a second structural member, wherein the second structural member is disposed around an edge of the first structural member;
a fan casing and a fan body, wherein the fan casing encloses the exterior of the fan body, the fan casing comprises a first portion and a second portion, the first portion and the first structural member jointly form a flat plate structure, the flat plate structure and the second structural member jointly enclose mounting space, and the fan body and the second portion are located in the mounting space; and
the first portion comprises a first surface, the first structural member comprises a second surface, both the first surface and the second surface are located on a side that is of the flat plate structure and that is away from the mounting space, and the second surface and the first surface are located on a same plane.

2. The fan module according to claim 1, wherein the fan body comprises a shaft base, fan blades, and a stator assembly, the shaft base is connected to the first portion, the stator assembly is connected to the shaft base, the fan blade is rotatably connected to the shaft base, and the fan blade comprises a magnetic element; and
the fan casing further comprises a communication hole, the electronic device further comprises a circuit board, the circuit board is located in the mounting space, and the circuit board extends into the fan casing through the communication hole and is electrically connected to the stator assembly.

3. The fan module according to claim 2, wherein
a protrusion structure is provided on a side that is of the first portion and that is close to the mounting space, a first sub-surface is provided on a side that is of the protrusion structure and that is close to the mounting space, the first sub-surface is provided opposite to the first surface, the first sub-surface is recessed toward a side close to the first surface to form a mounting groove, and the shaft base is mounted in the mounting groove.

4. The fan module according to claim 3, wherein the first sub-surface is parallel to the first surface and is perpendicular to a rotation axis of the fan blade.

5. The fan module according to claim 3 or 4, wherein the first portion further comprises a second sub-surface adjacent to the protrusion structure, the second sub-surface is provided opposite to the first surface, and the second sub-surface is parallel to the first surface and is perpendicular to the rotation axis of the fan blade.

6. The fan module according to claim 5, wherein a third sub-surface is provided on a side that is of the first structural member and that is close to the mounting space, the third sub-surface is provided opposite to the second surface, and the third sub-surface and the second sub-surface are located on a same plane.

7. The fan module according to claim 6, wherein the circuit board comprises a first plate portion, a second plate portion, and a bent portion, the first plate portion is connected to the first sub-surface, the second plate portion is connected to the second sub-surface and passes through the communication hole, and the bent portion is connected between the first plate portion and the second plate portion.

8. The fan module according to any one of claims 2 to 7, wherein the first portion and the first structural member are of an integrated structure.

9. The fan module according to claim 8, wherein the second portion comprises a frame and a cover plate, the frame is located between the first portion and the cover plate, the frame is disposed around edges of the first portion and the cover plate, and the frame and the cover plate are of an integrated structure.

10. The fan module according to claim 9, wherein the frame is detachably connected to the side that is of the first structural member and that is close to the mounting space, the fan module further comprises a sealing structure, and the sealing structure is located between the first portion and the frame.

11. The fan module according to claim 10, wherein a recessed structure is further provided on the side that is of the first portion and that is close to the mounting space, the recessed structure and the frame jointly enclose the communication hole, a part of the sealing structure is located in the communication hole, and the circuit board is located between the sealing structure and the recessed structure.

12. The fan module according to any one of claims 2 to 11, wherein the first structural member is provided with a through mounting opening, and at least a part of the first portion is located in the mounting opening.

13. The fan module according to claim 12, wherein the first structural member comprises a bottom plate and a lapping block, the bottom plate is provided with the through mounting opening, the second surface is provided on a side that is of the bottom plate and that is away from the mounting space, a side surface adjacent to the second surface is further provided on the bottom plate, and the side surface encloses the mounting opening; and
the lapping block is connected to a side that is of the bottom plate and that is close to the mounting space, in a direction that is parallel to the second surface and that points from the side surface to the rotation axis of the fan blade, the lapping block extends beyond the side surface, a surface that is of the lapping block and that is adjacent to the side surface is a lapping surface, and the lapping surface is in contact with the side that is of the first portion and that is close to the mounting space.

14. The fan module according to claim 13, wherein a part of the bottom plate and a part of the first portion jointly form a welding block, a third surface is provided on a side that is of the welding block and that is away from the mounting space, and the third surface, the first surface, and the second surface are located on a same plane.

15. The fan module according to claim 14, wherein the second portion comprises the frame and the cover plate, the frame is located between the first portion and the cover plate, the frame is disposed around the edge of the cover plate, and there is a preset distance between the frame and the side surface in the direction that is parallel to the second surface and that points from the side surface to the rotation axis of the fan blade.

16. The fan module according to any one of claims 13 to 15, wherein the electronic device may further comprise a decoration layer, and the decoration layer is located on a side that is of the bottom plate and the first portion and that is away from the mounting space.

17. An electronic device, comprising a mainboard and the fan module according to any one of claims 1 to 16, wherein the mainboard is connected to a fan body of the fan module.
